# EUROPÄISCHE PATENTSCHRIFT

(11) **EP 2 559 050 B1**
(45) Veröffentlichungstag und Bekanntmachung des Hinweises auf die Patenterteilung: **07.06.2017**
(21) Anmeldenummer: 11701194.0
(22) Anmeldetag: 10.01.2011
(51) Int. Cl.: H01J 37/305, H01J 37/12, C23C 14/32, H01J 37/32

(54) **TARGET FÜR FUNKENVERDAMPFUNG MIT RÄUMLICHER BEGRENZUNG DER AUSBREITUNG DES FUNKENS**
TARGET FOR ARC SOURCE WITH SPATIAL LIMITING OF THE SPARK MIGRATION
CIBLE POUR SOURCE D'ARC AVEC LIMITATION SPATIAL DE MIGRATION D'ARC

(30) Priorität: 17.05.2010 DE 102010020737; 16.04.2010 US 324929 P
(43) Veröffentlichungstag der Anmeldung: 20.02.2013
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT); HAGMANN, Juerg, CH-9468 Sax (CH)
(74) Vertreter: Kempkens, Anke
(86) Internationale Anmeldenummer: PCT/EP2011/000057
(87) Internationale Veröffentlichungsnummer: WO 2011/128004

(56) Entgegenhaltungen:
- WO-A1-00/16373
- DE-A1- 4 401 986
- JP-A- 62 218 562
- US-A- 5 298 136

## Beschreibung

Die vorliegende Erfindung betrifft ein Target für eine Funkenverdampferquelle nach dem Oberbegriff des Anspruchs 1, sowie eine dementsprechende Funkenverdampferquelle und ein Verfahren zu Herstellung von Schichten mittels Funkenverdampfen.

Unter Funkenverdampfen ist im Folgenden ein physikalisches Beschichtungsverfahren mittels Verdampfen unter Vakuum zu verstehen bei dem ein Kathodenbrennfleck von einer dafür vorgesehenen Oberfläche Material verdampft. Die Vorrichtung in der das zu verdampfende Material bereitgestellt wird im Folgenden Target genannt. Das Target bildet zusammen mit einer Zündvorrichtung zum Zünden des Funkens sowie einer Spannungsquelle zur Aufrechterhaltung des Funkens eine ARC-Quelle. Als ARC-Confinement wird im Folgenden die Begrenzung der Ausbreitung des Kathodenbrennflecks bezeichnet.

ARC-Quellen werden vorwiegend mit aufgeprägtem Magnetfeld betrieben. Dabei werden am Target magnetische Mittel vorgesehen, die zu einer magnetischen Feldlinienverteilung (im Folgenden vereinfacht Magnetfeld genannt) unter anderem oberhalb, dass heisst zumindest in der Nähe aber der Oberfläche des zu verdampfenden Targetmaterials ausserhalb des Targets führen, welche die Wandergeschwindigkeit des Kathodenbrennflecks auf der Targetoberfläche sowie die Entladungsbedingungen wie zum Beispiel die Entladungsspannung beeinflussen.

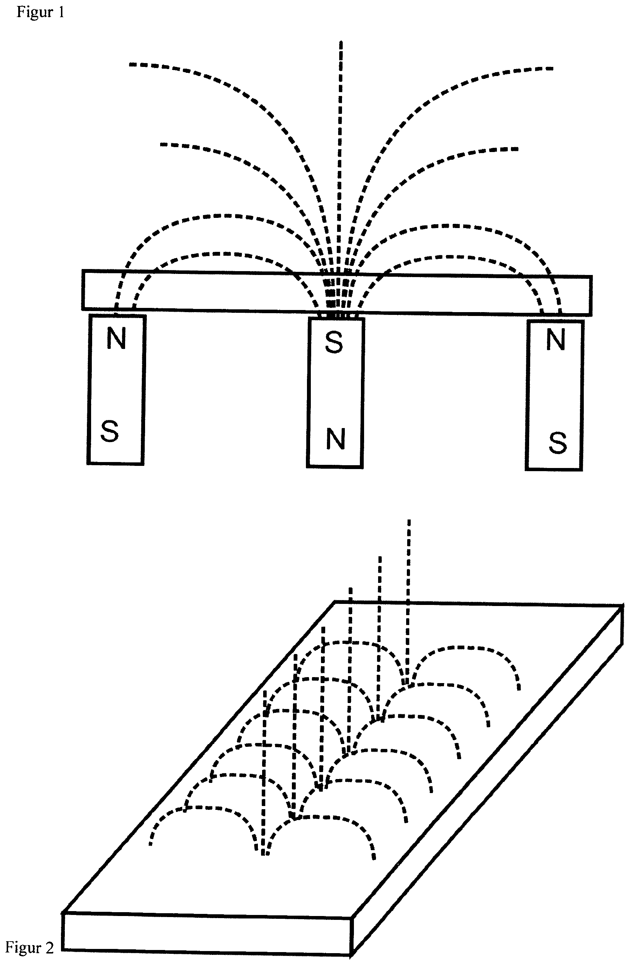

Ein Problem bei der Erzeugung des Magnetfeldes ist, dass bei einem Axialsymmetrischen Feld welches im Zentrum von null verschieden ist, die Feldlinien im Zentrum immer senkrecht zur Oberfläche aus dem Target austreten. Dies ist für ein Rundtarget schematisch in Figur 1 und für ein Rechtecktarget schematisch in Figur 2 dargestellt. In den Bereichen in denen die Feldlinien im Wesentlichen senkrecht zur Targetoberfläche stehen wird die Wandergeschwindigkeit des Kathodenbrennflecks stark heruntergesetzt. Dieser Effekt kann als Kollabieren des Kathodenbrennflecks im Zentrum bezeichnet werden, Es kommt zu einem verstärkten Materialabtrag mit verstärkter Droplet Bildung hinsichtlich Anzahl und auch Grösse in diesem Bereich. Droplets sind von der Oberfläche des Targets herausgeschleuderte im Wesentlichen flüssige, d.h. nicht verdampfte Konglomerate des Targetmaterials, welche sich als Makropartikel auf dem zu beschichtenden Substrat niederschlagen. Bei reaktiven Beschichtungsprozessen führt dies häufig dazu, dass die Konglomerate nicht mit dem Reaktivgas vollständig durchreagieren konnten.

Gegen dieses Kollabieren des Kathodenbrennflecks im Targetzentrum sind im Wesentlichen zwei Massnahmen bekannt.

Einerseits kann versucht werden das Kollabieren durch geschickte Wahl des Magnetsystems zu vermeiden. Dies wird beispielsweise durch divergierende Magnetfeldlinien erreicht. Allerdings ist bekannt, dass durch Fokussieren von Magnetfeldern das verdampfte Material verstärkt zum zu beschichtenden Substrat geführt werden kann und sich dadurch die Effizienz des Materialeinsatzes erhöht. Durch die Verwendung von divergierenden Magnetfeldlinien muss auf diesen Vorteil verzichtet werden.

Andererseits ist es bekannt Massnahmen zu ergreifen die den Kathodenbrennfleck, trotz senkrecht austretender magnetischer Feldlinien aus dem Zentralbereich des Tragets zu verbannen, d.h. auf Bereiche des Targets ausserhalb des Zentralbereichs einzuschränken, zu beschränken. Gemäss der WO 0016373 wird dementsprechend das Problem des Kollabierens im Zentralbereich des Kathodenbrennflecks dadurch abgeschwächt, dass im zentralen Bereich des Targets eine Blende vorgesehen ist, deren Material eine geringere Sekundärelektronenausbeute aufweist. Als Blendenmaterial wird dort zum Beispiel Bornitrid verwendet. Bei diesem Ansatz zeigt sich allerdings das Problem, dass durch Beschichtung der Blendenoberfläche diese elektrisch leitend wird, der Kathodenbrennfleck auf die Blendenoberfläche wandern kann und es damit zu unerwünschten Bestandteilen in der aufzubauenden Schicht kommt.

Der vorliegenden Erfindung liegt die Aufgabe zugrunde, die Nachteile des Stand der Technik zumindest teilweise zu überwinden. Dabei sollte bei den getroffenen Massnahmen weiterhin die Tauglichkeit im Produktionsumfeld von Lohnbeschichtungsbetrieben gewährleistet sein. Entsprechend gelten Anforderungen an tiefe Kosten, Prozessstabilität und Wartungsfreundlichkeit.

Erfindungsgemäss wird die Aufgabe entsprechend dem kennzeichnenden Teil des Anspruchs 1 gelöst. Unteransprüche bilden weitere vorteilhafte Ausführungsformen.

Die Erfinder haben erkannt, dass ein Problem der in der WO 0016373 darin besteht, dass aufgrund des Kontaktes zwischen Blende und Verdampfungsmaterial mit zunehmender Beschichtung eine elektrisch leitende Verbindung aufgebaut wird, welche die Funkenentladung auf der Blendenoberfläche trotz geringerer Sekundärelektronenausbeute ermöglicht.

Erfindungsgemäss wird daher der Kathodenbrennfleck sehr effizient aus dem Zentralbereich der Targetoberfläche verbannt, indem in diesem Bereich der Elektronennachschub dauerhaft während des Beschichtungsprozesses unterbunden wird, d.h. die Funkenentladung mangels Stromtragfähigkeit ausgeschlossen ist. Dies wird dadurch erzielt, dass
der Zentralbereich dauerhaft isoliert und auf elektrisch floatendem Potential angeordnet ist. Erstaunlicherweise kann dann, wenn dieser Elektronennachschub im Zentralbereich des Targets nachhaltig unterbunden ist, als Blendenmaterial sogar das zur restlichen Targetoberfläche identische Material verwendet werden. Die Verwendung von Materialien welche eine geringere Sekundärelektronenausbeute Aufweisen ist daher nicht mehr Voraussetzung. Sollte der Kathodenbrennfleck zufällig kurzzeitig auf die Blende driften, so führt dies in diesem Fall nicht zur Verunreinigung der Schichten.

Die Erfindung wird nun anhand von Beispielen und Figuren im Detail beispielhaft dargestellt. Dabei zeigt:
Figur 3 zeigt eine erfindungsgemässe Ausführungsform eines Targets mit einer Scheibe in unmagnetischer Ausführung und schematisch den Feldlinienverlauf
Figur 4 eine erfmdungsgemässe Ausführungsform eines Targets mit einer Scheibe in magnetischer Ausführung mit weichmagnetischem Material und schematisch den Feldlinienverlauf

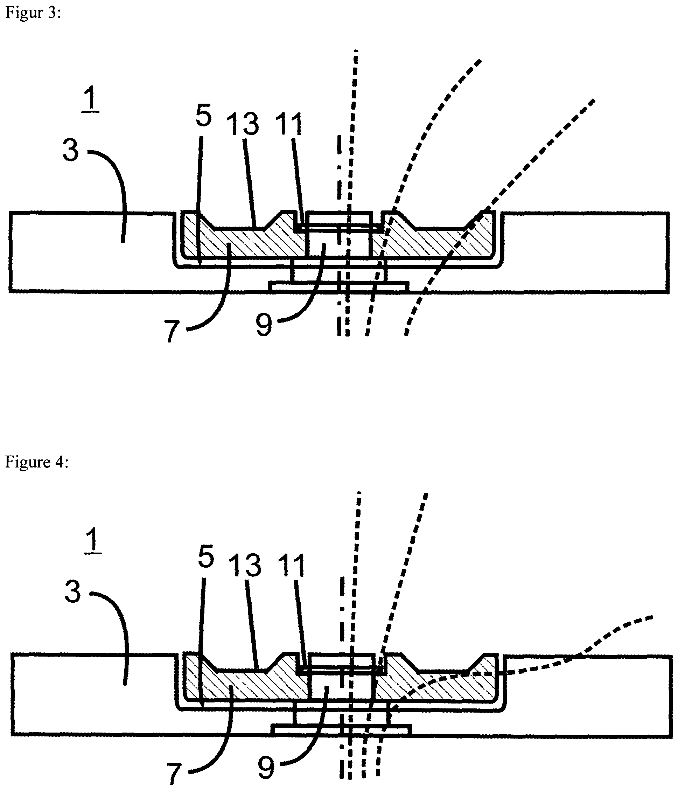

Gemäss einem ersten Ausführungsbeispiel umfasst das Target 1 wie in Figur 3 gezeigt ein Targetmaterial 3, im Beispiel Titan mit einer Einformung 5 im zentralen Bereich zur Aufnahme einer elektrisch isoliert angebrachten Scheibe 7 welche an einem Isolatorpin 9 mittes eines Sicherungsrings 11 gehalten wird. Als Isolatorpin 9 eignet sich beispielsweise keramisches elektrisch nicht leitendes Material. Die Abstände zwischen Targetmaterial 3 und der Scheibe 7 betragen ca zwischen 1.5mm und 3.5mm. Bei noch grösserem Abstand besteht die Gefahr, dass der Kathodenbrennfleck die auf floatendem Potential liegende Scheibe 7 unterläuft. Bei noch kleinerem Abstand als 1.5mm besteht die Gefahr, dass es durch Aufwachsen von Beschichtungsmaterial zu einem elektrischen Kontakt zwischen Targetmaterial 3 und Scheibe 7 kommt.

Zur Herstellung des Targets wird vorzugsweise zunächst eine Platte aus Targetmaterial auf ein Trägerplatte (nicht gezeigt) aufgebracht, welche sowohl zur Kühlung als auch zur elektrischen Kontaktierung dient. Anschliessend erst wird die mechanische Arretierung des Isolatorpins 9, der Scheibe 7 und dem Sicherungsring 11 vollzogen.

In vielen Anwendungen ist das Target 1 an den Seitenwänden der Beschichtungskammer angeordnet. Dies bedeutet für ein Rundtarget dass die Symmetrieachse des Targets 1 in der Horizontalen liegt. Die Scheibe 7 umfasst im Beispiel ein Loch mit dem sie auf den Isolatorpin 9 geschoben wird. Vorzugsweise wird der Durchmesser des Loches zumindest um einige Zehntel Millimeter grösser gewählt als der Durchmesser des Teils Isolatorpins 9 der durch das Loch geschoben wird. Aufgrund der Schwerkraft liegt daher die Scheibe 7 auf einer Linie auf dem oberen Mantelteil des Isolatorpins 9 auf. Der Sicherungsring 11 ist, wie in der Figur 3 gezeigt in eine zentrale Einformung der Scheibe 7 abgesenkt. Dadurch verkleinert sich die Auflagelinie weiter und im ungünstigen Fall liegt der Schwerpunkt der Scheibe so, dass die Scheibe 7 aufgrund der Toleranz verkippt auf dem Mantel des Isolatorpins 9 gelagert wird. Um dies zu verhindern umfasst die Scheibe 7 gemäss einer erfinderischen Weiterbildung dieser Ausführungsform eine oder mehrere Einformungen 13. Diese Einformungen 13 bewirken, dass sich der Schwerpunkt der Scheibe 7 auf der Achse weg vom Sicherungsring 11 verschiebt und so die Scheibe 7 nicht verkippt gelagert wird.

Die Scheibe 7 besteht gemäss der vorliegenden Ausführungsform aus elektrisch leitfähigem, beispielsweise metallischem Material. Gemäss einer besonders bevorzugten Ausführungsform kann die floatende Scheibe 7 auch als weichmagnetischer Werkstoff ausgeführt werden, womit erreicht werden kann, dass die Feldlinien an der äusseren Kante der Scheibe senkrecht austreten und damit im Wesentlichen parallel zur Targetoberfläche liegen, wie in Figur 4 mittels gestrichelten Linien auf der rechten Seite dargestellt. Damit ist eine schnelle Wandergeschwindigkeit des Kathodenbrennflecks über den ganzen verbleibenden Targetbereich gewährleistet.

In der vorliegenden Beschreibung wurde ein Target für eine ARC-Quelle offenbart mit einem ersten Körper 3 aus einem zu verdampfenden Material welcher im Wesentlichen in einer Ebene eine zur Verdampfung vorgesehene Oberfläche umfasst, wobei die Oberfläche in dieser Ebene einen zentralen Bereich umgibt, dadurch gekennzeichnet, dass in dem zentralen Bereich ein von dem ersten Körper 3 elektrisch dergestalt isolierter zweiter Körper 7 der vorzugsweise in Scheibenform ausgebildet ist, vorgesehen ist, dass vom zweiten Körper 7 im Wesentlichen keine Elektronen zur Aufrechterhaltung eines Funkens bereitgestellt werden können.

Vorzugsweise umfasst der erste Körper 3 im zentralen Bereich eine Einformung 5 in die der zweite Körper 7 abgesenkt und mittels eines Isolierpins 9 befestigt ist, wobei der Abstand zwischen dem ersten Körper 3 und dem zweiten Körper 9 einen oder mehrere Werte zwischen einschliesslich 1.5 mm und 3.5 mm einnimmt, wobei in einer besonders bevorzugten Ausführungsform der Körper 7 zumindest an der Oberfläche, welche aus der Einformung 5 herausragt Material aufweisst, welche dem Material des Körpers 3 entspricht.

Der zweite Körper 7 kann eine oder mehrere Einformung 13 umfassen dergestalt, dass der auf der Achse liegende Schwerpunkt des zweiten Körpers 7 in Höhe des Mantels des Loches zu liegen kommt.

In einer weiteren besonders bevorzugten Ausführungsform ist der zweite Körper 7 aus weichmagnetischem Material ausgeführt.

## Patentansprüche

1. Target für eine ARC-Quelle mit einem ersten Körper (3) aus einem zu verdampfenden Material welcher im Wesentlichen in einer Ebene eine zur Verdampfung vorhandene Oberfläche umfasst, wobei die Oberfläche in dieser Ebene einen zentralen Bereich umgibt, **dadurch gekennzeichnet, dass** in dem zentralen Bereich ein von dem ersten Körper (3) elektrisch isolierter zweiter Körper (7) der vorzugsweise in Scheibenform ausgebildet ist, vorhanden ist, und der zweite Körper (7) auf elektrisch floatendem Potential angeordnet ist.

2. Target nach Anspruch 1, **dadurch gekennzeichnet, dass** der erste Körper (3) im zentralen Bereich eine Einformung (5) umfasst in die der zweite Körper (7) abgesenkt und mittels eines Isolierpins (9) befestigt ist, wobei der Abstand zwischen dem ersten Körper (3) und dem zweiten Körper (9) einen oder mehrere Werte zwischen einschliesslich 1.5 mm und 3.5 mm einnimmt.

3. Target nach Anspruch 2, **dadurch gekennzeichnet, dass** der zweite Körper (7) zumindest an der
Oberfläche, welche aus der Einformung (5) herausragt Material aufweist, welche dem Material des ersten Körpers (3) entspricht.

4. Target nach einem der Ansprüche 2 oder 3, **dadurch gekennzeichnet, dass** der zweite Körper (7) in Scheibenform ausgebildet ist und ein Loch umfasst.

5. Target nach Anspruch 4, **dadurch gekennzeichnet, dass** der zweite Körper (7) zumindest eine Einformumg (13) umfasst dergestalt, dass der auf der Achse liegende Schwerpunkt des zweiten Körpers (7) in Höhe des Mantels des Loches zu liegen kommt.

6. Target nach einem der vorangehenden Ansprüche, **dadurch gekennzeichnet dass** der zweite Körper aus weichmagnetischem Material ausgeführt ist.

## Claims

1. Target for an ARC source having a first body (3) of a material to be vaporized, which essentially comprises in one plane a surface which is intended to be vaporized, wherein the surface surrounds in this plane a central area, **characterized in that** in the central area a second body (7) is provided, which is preferably in the form of a disk and is electrically isolated from the first body (3), and the second body (7) is arranged on an electrically floating potential.

2. Target according to claim 1, **characterized in that** the first body (3) in the central area comprises a recess (5) into which the second body (7) is lowered and fastened by means of an isolating pin (9), wherein the distance between the first body (3) and the second body (9) has one or several values between including 1.5 mm and 3.5 mm.

3. Target according to claim 2, **characterized in that** the second body (7) comprises, at least at the surface that protrudes from the recess (5), material that corresponds to the material of the first body (3).

4. Target according to one of the claims 2 or 3, **characterized in that** the second body (7) is designed in the form of a disk and comprises a hole.

5. Target according to claim 4, **characterized in that** the second body (7) comprises at least one recess (13) designed in such a way that the center of gravity of the second body (7) being on the axis comes to rest at the level of the jacket of the hole.

6. Target according to one of the preceding claims, **characterized in that** the second body is made of a magnetically soft material.

## Revendications

1. Cible pour une source ARC ayant un premier corps (3) d'un matériau à vaporiser qui comprend essentiellement dans un plan une surface destinée à la vaporisation, la surface entourant dans ce plan une zone centrale, **caractérisée par le fait qu'**il y a dans la zone centrale un second corps (7) qui est isolé électriquement du premier corps (3) et formé de préférence en forme de disque, et le second corps (7) est disposé à potentiel électriquement flottant.

2. Cible selon la revendication 1, **caractérisée par le fait que** le premier corps (3) comprend dans la zone centrale une cavité (5) dans laquelle le second corps (7) est abaissé et fixé au moyen d'une tige isolante, la distance entre le premier corps (3) et le second corps (9) ayant une ou plusieurs valeurs entre inclusivement 1.5 mm et 3.5 mm.

3. Cible selon la revendication 2, **caractérisée par le fait que** le second corps (7) comprend, du moins au surface saillissant de la cavité (5), du matériau qui correspond au matériau du premier corps (3).

4. Cible selon une des revendications 2 ou 3, **caractérisée par le fait que** le second corps (7) est formé en forme de disque et comprend un trou.

5. Cible selon la revendication 4 **caractérisée par le fait que** le second corps (7) comprend du moins une cavité de manière que le centre de gravité du second corps (7) étant sur l'axe se situe à la hauteur du manteau du trou.

6. Cible selon une des revendications précédentes **caractérisée par le fait que** le second corps est fait de matériau magnétique doux.
